# EUROPÄISCHE PATENTSCHRIFT

(11) **EP 2 741 054 B1**
(45) Veröffentlichungstag und Bekanntmachung des Hinweises auf die Patenterteilung: **19.07.2017**
(21) Anmeldenummer: 13005292.1
(22) Anmeldetag: 11.11.2013
(51) Int. Cl.: G01D 4/00, G01R 22/06

(54) **Smart Meter**
Smart meter
Compteur triphasé intelligent

(30) Priorität: 13.11.2012 DE 102012022132
(43) Veröffentlichungstag der Anmeldung: 11.06.2014
(73) Patentinhaber: TQ-Systems GmbH, 82229 Seefeld (DE)
(72) Erfinder: Seliger, Raik, 09247 Chemnitz (DE); Köthe, Daniel, 09131 Chemnitz (DE); Budjko, Valeri, 04315 Leipzig (DE)
(74) Vertreter: Grättinger Möhring von Poschinger Patentanwälte Partnerschaft

(56) Entgegenhaltungen:
- DE-A1-102007 047 920
- DE-A1-102010 024 131
- DE-A1-102011 100 964
- "Voltcraft", OPERATING INSTRUCTIONS,, 1. Dezember 2011 (2011-12-01), Seiten 1-68, XP007922525,
- "Wechselstrom-Elektrizitätszähler - Teil 1: Allgemeine Anforderungen, Prüfungen und Prüfbedingungen - Messeinrichtungen (Genauigkeitsklassen A, B und C); Deutsche Fassung EN 50470-1:2006 = Electricity metering equipment (a.c.) - Part 1: General requirements, tests and test conditions - Metering equip", DEUTSCHE NORMEN. DIN NORM,, Bd. 50470-1 (VDE 0418-0-1), 1. Mai 2007 (2007-05-01), Seite 64pp, XP009175997,

## Beschreibung

Die vorliegende Erfindung betriff einen Smart-Meter mit einer Elektronik zur Erfassung des Stromverbrauchs und zur Ausgabe von den Stromverbrauch repräsentierenden Daten über eine Datenkommunikationsschnittstelle umfassend ein die Elektronik aufnehmendes Gehäuse, welches zum Einbau in eine Hutschiene eines Verteilerkastens für ein Niederspannungsnetz geeignet ist. Das Dokument "VOLTCRAFT VSM-102, 3 Phasen Drehstromzähler, digital", Hirschau, 2011, beschreibt einen solchen Smart-Meter. Smart-Meter, also "intelligente" Strommessgeräte mit einem zum Einbau in eine Hutschiene (DIN Rail) eines Verteilerkastens geeigneten Gehäuse sind aus dem Stand der Technik in verschiedenen Ausführungen bekannt und dienen zur möglichst komfortablen Bereitstellung von Informationen über den Stromverbrauch, die zu diesem Zweck über eine Datenkommunikationsschnittstelle an externe Datenverarbeitungsgeräte ausgegeben bzw. von diesen bei Bedarf ausgelesen werden können.

Aufgrund der hohen Sicherheitsanforderungen, insbesondere im Hinblick auf den Überspannungsschutz, haben die aus dem Stand der Technik bekannten Smart-Meter der eingangs genannten Art jedoch eine vergleichsweise große Baugröße, da beim Einbau eines solchen Geräts in einen Verteilerkasten, z.B. den Sicherungskasten eines Privathaushalts, zwischen der Datenkommunikationsschnittstelle des Smart-Meters und der im Gerät integrierten Elektronik, welche an den Dreiphasenwechselstrom (eines 230 V bzw. 400 V Niederspannungsnetzes) angeschlossen wird, eine 8 kV-Schutzisolierung, d.h. eine Isolierung mit einer Isolationsfestigkeit von 8kV, vorzusehen ist, die derzeit nicht bzw. nicht mit vertretbaren Kosten mittels handelsüblichen elektrischen Bauteilen geringer Größe realisiert werden kann.

Die in einer Hutschiene eines Verteilerkastens montierbaren Smart-Meter mit einer Datenkommunikationsschnittstelle bestehen daher zumeist aus einer Mehrzahl an separat in den Verteilerkasten einzubauenden Modulen, von denen lediglich ein nicht direkt mit dem Dreiphasenwechselstrom verbundenes Modul die Datenkommunikationsschnittstelle, z.B. eine LAN-Schnittstelle, zur Ausgabe des mittels eines anderen Moduls gemessenen Stromverbrauchs aufweist. Diese Systemgestaltung mit mehreren Modulen ist jedoch sowohl aus Kostengründen als auch hinsichtlich des höheren Montageaufwands nachteilig.

Vor dem Hintergrund des vorstehend erläuterten Stands der Technik ist es die Aufgabe der vorliegenden Erfindung, einen Smart-Meter der eingangs genannten Art bereitzustellen, der als günstiges Einzelgerät in einer besonders kompakten Bauweise ohne der Notwendigkeit zur Installation zusätzlicher Module einen möglichst großen Funktionsumfang bereitstellen kann.

Diese Aufgabe wird mit einem Smart-Meter nach Anspruch 1 gelöst, der neben den eingangs genannten Merkmalen dadurch gekennzeichnet ist, dass die Elektronik des Smart-Meters einen Primärschaltkreis mit Anschlüssen für die drei Phasen eines Dreiphasenwechselstroms, einen Sekundärschaltkreis mit mindestens einer auf einer Bedienseite des Gehäuses angeordneten Datenkommunikationsschnittstelle und einen zwischen dem Primärschaltkreis und dem Sekundärschaltkreis angeordneten Messschaltkreis mit einem Smart-Metering-Mikrochip aufweist, wobei der Messschaltkreis sowohl gegenüber dem Primärschaltkreis als auch gegenüber dem Sekundärschaltkreis eine Schutzisolierung mit einer Isolationsfestigkeit von jeweils mindestens 3 kV aufweist, wobei die Summe der Isolationsfestigkeiten der beiden Schutzisolierungen (A, B) wenigstens 8 kV beträgt und wobei der Sekundärschaltkreis gegenüber dem Primärschaltkreis eine 8 kV-Schutzisolierung aufweist.

Aufgrund der erfindungsgemäßen Topologie der Elektronik des Smart-Meters, bei der die Elektronik in (wenigstens) drei in spezifischer Weise gegeneinander schutzisolierte Schaltkreise unterteilt ist, kann der erfindungsgemäße Smart-Meter - trotz der erforderlichen elektrotechnischen Kopplung der verschiedenen Schaltkreise - in besonders kompakter Bauweise realisiert werden. Die erfindungsgemäß verlangte Schutzisolierung mit einer Isolationsfestigkeit von jeweils wenigstens 3 kV zwischen Primärschaltkreis und Messschaltkreis sowie zwischen Messschaltkreis und Sekundärschaltkreis, wobei die Summe der beiden vorgenannten Isolationsfestigkeiten wenigstens 8 KV beträgt, kann dabei auch unter beengten Platzverhältnissen mit vergleichsweise kostengünstigen Bauteilen erfolgen, sogar wenn alle drei vorgenannten Schaltkreise zumindest teilweise oder vollständig auf ein- und derselben Platine/Leiterplatte angeordnet sind, was im Rahmen der vorliegenden Erfindung vorteilhaft vorgesehen sein kann. Ferner kann man dabei gleichzeitig den hohen Sicherungsanforderungen an einen in einen Verteilerkasten eingebauten Smart-Meter gerecht werden, da die auf einer Bedienseite des Geräts zugängliche Datenkommunikationsschnittstelle, welche mit dem Sekundärschaltkreis gekoppelt ist, durch das erfindungsgemäße Konzept hinreichend gegenüber dem Primärschaltkreis (sowohl direkt als auch indirekt über den Messschaltkreis) schutzisoliert ist.

In einer ersten bevorzugten Weiterbildung der Erfindung ist dabei vorgesehen, dass es bei den Schutzisolierungen zwischen dem Primärschaltkreis und dem Messschaltkreis sowie zwischen dem Messschaltkreis und dem Sekundärschaltkreis jeweils um eine 4 kV-Schutzisolierung handelt.

Soweit vorstehend von einer 4 kV-Schutzisolierung bzw. einer 8 kV-Schutzisolierung gesprochen ist, ist damit eine Schutzisolierung mit einer Isolationsfestigkeit von jeweils wenigstens 4 kV bzw. wenigstens 8 kV gemeint, wobei es im Rahmen der vorliegenden Erfindung zum Zwecke der gewünschten Minimierung der Baugröße des Smart-Meters selbstverständlich vorteilhaft ist, die jeweilige Mindest-Isolationsfestigkeit nicht unnötig (weit) zu überschreiten. Isolationsfestigkeit bezeichnet die Eigenschaft, der genannten Spannung für einen hinreichend langen Zeitraum, z.B. 60 s, ohne Spannungsdurchschlag Stand zu halten.

Es sei angemerkt, dass unter einem Smart-Metering-Mikrochip vorliegend ein Mikrochip zu verstehen ist, der zur Messung des Stromverbrauchs in einem Dreiphasenwechselstrom eingerichtet ist und der den gemessenen Stromverbrauch in Form geeigneter Daten ausgeben kann. Vorteilhaft ist der Smart-Metering-Mikrochip dazu eingerichtet, die gemessenen Daten zum Stromverbrauch auf geeignete Weise aufzubereiten und/oder diese als Datenlogger auf einem in das Gehäuse integriertem Datenspeicher mit einer Aktualisierungsrate größer gleich 1 Hz zu speichern und/oder über die Datenkommunikationsschnittstelle auszugeben. Es versteht sich von selbst, dass der Smart-Metering-Mikrochip bevorzugt eine Messgenauigkeit aufweist, die derjenigen eines zu Abrechnungszwecken zugelassenen Stromzählers entspricht.

In einer bevorzugten Weiterbildung des erfindungsgemäßen Smart-Meters ist vorgesehen, dass die 4 kV-Schutzisolierung zwischen Messschaltkreis und Primärschaltkreis einerseits und Sekundärschaltkreis andererseits dadurch realisiert ist, dass zwischen allen leitfähigen Elementen des Messschaltkreises und des Primärschaltkreises sowie zwischen allen leitfähigen Elementen des Messschaltkreises und des Sekundärschaltkreises stets ein Mindest-Luftabstand von 3 mm und ein platinenseitiger Mindest-Kriechstromabstand von 3 mm (bevorzugt von 4 mm) vorgesehen sind, wobei elektrische Bauteile, die den Primärschaltkreis mit dem Messschaltkreis sowie den Messschaltkreis mit dem Sekundärschaltkreis koppeln, ihrerseits jeweils eine 4 kV-Schutzisolierung aufweisen und dass die 8 kv-Schutzisolierung zwischen Primär- und Sekundärschaltkreis dadurch realisiert ist, dass zwischen allen leitfähigen Elementen des Primär- und Sekundärschaltkreises ein Mindest-Luftabstand von 6 mm und ein platinenseitiger Mindest-Kriechstromabstand von 6,3 mm vorgesehen sind. Gleichermaßen kann bzw. muss ersichtlich ein den Primär- mit dem Sekundärkreis koppelndes Bauteil, falls ein solches z.B. in Form einer mit dem Primärschaltkreis verbundenen Stromversorgung für den Sekundärschaltkreis vorgesehen ist, mit einer Isolationsfestigkeit von 8 kV schutzisoliert sein. Wenn jedoch ein den Primär- mit dem Sekundärkreis koppelndes Netzteil bereits einen eigenen Überspannungsschutz, z.B. in Form eines geeigneten Varistors, enthält, so kann ggfs. auch ein Netzteil mit einer Isolationsfestigkeit von mindestens 4 kV Verwendung finden. Entsprechende Netzteile sind - auch in kostengünstiger und kompakter Bauweise - aus dem Stand der Technik bekannt.

Die vorstehend erläuterten Maßnahmen zur Schutzisolierung der verschiedenen Schaltkreise können ersichtlich in einem kompakten Gerät realisiert werden, um damit gleichzeitig das erforderliche Maß an Überspannungsschutz bereit zu stellen.

Ein voll funktionsfähiges Ausführungsbeispiel eines erfindungsgemäßen Smart-Meters, das auch die nachfolgend noch näher beschriebenen Merkmale aufweist, hat eine Gehäusebreite von 4 TE (Teilungseinheiten gemäß DIN 43880) zu je 17,5 mm, also eine Gesamtbreite von nur 70 mm, so dass im Rahmen der vorliegenden Erfindung erstmals ein zum Einbau in die Hutschiene eines Verteilerkastens geeigneter Smart-Meter, der eine auf einer Bedienseite des Gehäuses zugängliche Datenkommunikationsschnittstelle aufweist, mit einer maximalen Gehäusebreite von 4 Teilungseinheiten zu je 17,5 mm bereitgestellt werden kann, was ebenfalls eine bevorzugte Weiterbildung der vorliegenden Erfindung ist.

Eine abermals bevorzugte Weiterbildung der vorliegenden Erfindung sieht vor, dass die mindestens eine Datenkommunikationsschnittstelle eine LAN- oder WLAN-Schnittstelle ist.

Nochmals bevorzugt sind in einem erfindungsgemäßen Smart-Meter jedoch wenigstens zwei Datenkommunikationsschnittstellen vorgesehen, von denen die erste Datenkommunikationsschnittstelle eine LAN-Schnittstelle ist, wobei die wenigstens eine weitere Datenkommunikationsschnittstelle eine WLAN-Schnittstelle, eine Powerline-Schnittstelle, eine USB-Schnittstelle und/oder eine Schnittstelle zu einem Bus- oder einem Feldbussystem ist.

Dabei kann der erfindungsgemäße Smart-Meter herstellungsseitig vorteilhaft so vorbereitet sein, dass in jedem Fall eine LAN-Schnittstelle, z.B. in Form einer hierfür üblichen RJ-45-Steckbuchse, zum Anschluss des Smart-Meters an ein Datennetzwerk vorgesehen ist und dass in dem Smart-Meter und an dessen Gehäuse ein Einbauplatz für eine weitere Schnittstelle vorgesehen ist, die wahlweise als WLAN-Schnittstelle, als Powerline-Schnittstelle, als USB-Schnittstelle oder als Schnittstelle zu einem Bus- oder Feldbussystem ausgestaltet ist.

Vorteilhaft ist der Smart-Meter dabei auch zur Steuerung wenigstens eines externen Geräts über eine der vorgenannten Datenkommunikationsschnittstellen eingerichtet, in welchem Zusammenhang - nochmals bevorzugt - ggfs. auch die Signale von wenigstens einem an den Smart-Meter angeschlossenen Sensor berücksichtigt werden können.

In bevorzugter Weise kann dann eine an dem Smart-Meter vorgesehene LAN-Schnittstelle zum Auslesen und Programmieren des Smart-Meters vorgesehen sein, während wenigstens eine weitere Schnittstelle und die Elektronik des Smart-Meters dazu eingerichtet sind, zur Steuerung sonstiger externer Geräte zu dienen, die dann z.B. über ein Feldbussystem von dem ebenfalls an das Feldbussystem angeschlossenen Smart-Meter gesteuert werden können. Bei geeigneter Programmierung des Smart-Meters, der dann vorteilhaft eine speicherprogrammierbare Steuerung beinhaltet, kann dieser sowohl zur Überwachung des Stromverbrauchs (und der hieraus bei geeigneter Programmierung des Smart-Meters berechenbaren Stromkosten) als auch gleichzeitig als Hausautomationszentrale zur Steuerung externer Geräte dienen. Externe Geräte könne dabei über eine der gegebenen Datenkommunikationsschnittstellen und den korrespondierenden Kommunikationsweg (z.B. Powerline, Bussystem, Feldbus) von dem Smart-Meter gesteuert werden.

In besonders bevorzugter Weise kann schließlich noch vorgesehen sein, dass in das Gehäuse des Smart-Meters auch ein Webserver integriert ist, so dass der von dem Smart-Meter ermittelte Stromverbrauch von externen Geräten, z.B. auch von Mobiltelefonen über eine geeignete Software ("App"), über das Internet abgefragt werden kann, ohne dass es hierzu eines separaten Servers bedarf. Von Vorteil ist dabei, wenn der in den Smart-Meter integrierte Webserver nicht nur zur Anzeige und Darstellung von Daten zum Stromverbrauch dient, sondern - durch geeignete Gestaltung der Elektronik - gleichzeitig zur Programmierung oder Steuerung des Smart-Meters, z.B. in Zusammenhang mit der Steuerung externer Geräte eingesetzt werden kann. Falls dann z.B. via Feldbus verschiedene externe Geräte (z.B. eine Heizung, eine Hausschließanlage, die Beleuchtung des Hauses, elektrische Jalousien, etc.) ansteuerbar sind, so hat der Nutzer mittels des an den Feldbus und an das - mit dem Internet verbundene - Hausnetzwerk angeschlossenen Smart-Meters gleichzeitig die Möglichkeit, via Mobiltelefon oder einem sonstigen mit dem Internet verbundenen Datenverarbeitungsgerät, die externen Geräte zu steuern.

All dies kann im Rahmen der vorliegenden Erfindung, wie dies vorstehend bereits erläutert wurde, mittels eines einzigen kompakten Geräts, das in dem Sicherungsschrank eines Haushalts zu verbauen ist, realisiert werden.

Nachfolgend wird ein Ausführungsbeispiel der Erfindung anhand der Zeichnung näher erläutert. Dabei zeigt:
- Fig. 1: eine dreidimensionale Ansicht eines Ausführungsbeispiels eines erfindungsgemäßen Smart-Meters,
- Fig. 2: ein Isolationsdiagramm zur Veranschaulichung der Trennung der verschiedenen Schaltkreise des Smart-Meters aus Fig. 1 und
- Fig. 3: ein Blockschaltbild zur Veranschaulichung der Systemarchitektur eines erfindungsgemäßen Smart-Meters.

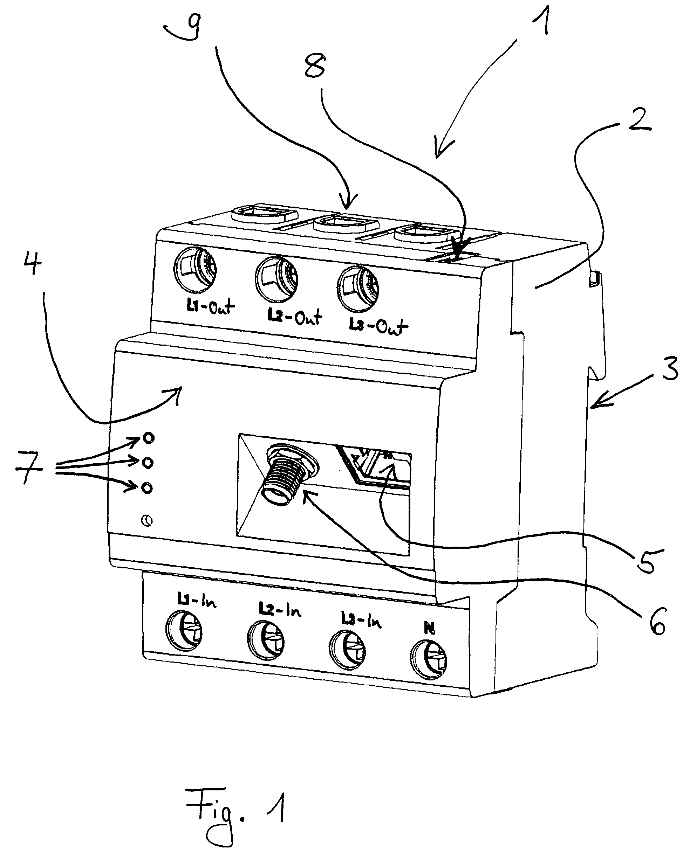

Fig. 1 zeigt ein Ausführungsbeispiel eines erfindungsgemäßen Smart-Meters 1 mit einer - in das Gehäuse 2 des Smart-Meters 1 integrierten und daher in Fig. 1 nicht erkennbaren Elektronik zur Erfassung des Stromverbrauchs und zur Ausgabe von den Stromverbrauch repräsentierenden Daten. Das Gehäuse 2 ist auf seiner Rückseite 3 in üblicher Weise zum Einbau in die Hutschiene (DIN-Rail) eines - nicht dargestellten - Verteilerkastens für ein Niederspannungsnetz geeignet.

Im unteren Bereich der Frontseite 4 des Gehäuses 2 sind insgesamt vier - als Eingang dienende - Anschlüsse L1-In, L2-In, L3-In, N für die drei Phasen L1, L2, L3 eines Dreiphasenwechselstroms sowie für einen Nullleiter N vorgesehen, die mit dem Primärschaltkreis der Elektronik des Smart-Meters verbunden sind. Im oberen Bereich der Frontseite 4 des Gehäuses 2 sind weitere drei mit dem Primärschaltkreis verbundene Anschlüsse L1-Out, L2-Out, L3-Out vorgesehen, die als Ausgang für die drei Phasen L1, L2, L3 des Dreiphasenwechselstroms dienen. Die oberen und unteren Bereiche der Frontseite 4 sind, sobald der erfindungsgemäße Smart-Meter 1 bestimmungsgemäß in einem üblichen Verteilerkasten verbaut ist, in der Regel durch Blenden abgedeckt.

Auf der die Bedienseite des Smart-Meters 1 darstellenden Frontseite 4 des Gehäuses 2 sind ferner zwei Datenkommunikationsschnittstellen 5, 6 vorgesehen, die mit dem hinreichend schutzisolierten Sekundärschaltkreis der Elektronik des Smart-Meters gekoppelt sind, wobei die in Fig. 1 rechts dargestellte Schnittstelle 5 eine LAN-Schnittstelle in Form einer RJ-45-Steckbuchse und die links dargestellte Schnittstelle 6 eine WLAN-Schnittstelle ist, auf welche eine (nicht dargestellte) Antenne für die drahtlose Datenkommunikation aufzuschrauben ist.

Ferner befinden sich an der Frontseite 4 des Gehäuses noch drei verschiedenfarbige LED-Anzeigen 7, welche aus Gründen des Überspannungsschutzes ebenfalls mit dem Sekundärschaltkreis verbunden sind und zur Signalisierung des Betriebszustands des Smart-Meters 1 dienen.

An der Gehäuseoberseite 9 ist schließlich noch eine Schnittstelle 8 zu einem externen Bussystem vorgesehen, über welches externe Sensoren an den Smart-Meter 1 anschließbar sind, um ggfs. deren Messwerte bei einer Steuerung externer Geräte berücksichtigen zu können.

Das Gehäuse 4 weist eine Gehäusebreite von insgesamt nur vier Teilungseinheiten zu je 17,5 mm auf, so dass der Smart-Meter 1 - in Anbetracht der gegebenen Funktionsvielfalt (siehe unten) - ein außerordentlich kompaktes Gerät darstellt.

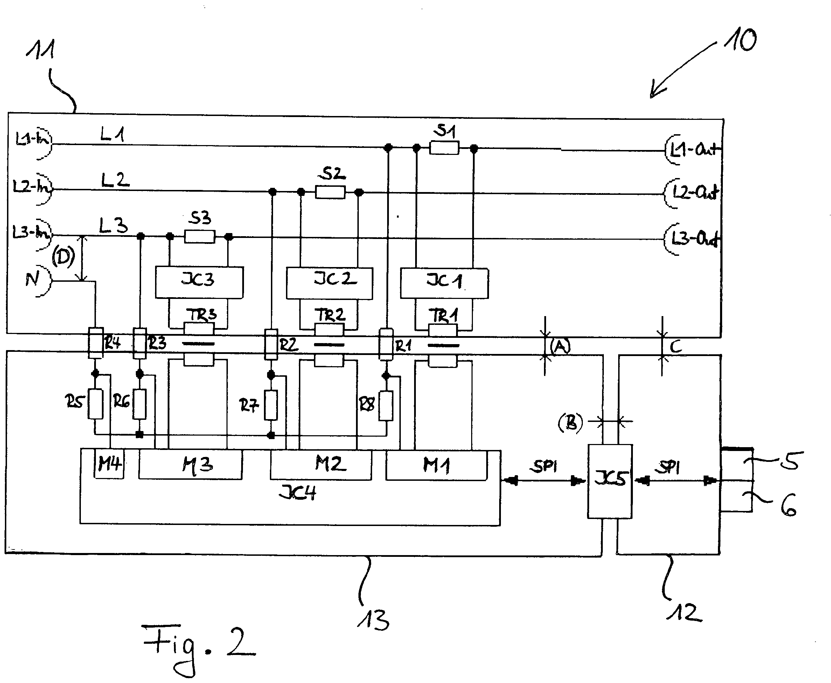

Fig. 2 zeigt in einer schematischen Darstellung zur Illustration des erfindungsgemäßen Isolationskonzepts die wesentlichen Komponenten der innerhalb des Gehäuses 2 des Smart-Meters 1 aus Fig. 1 verbauten Elektronik 10, die vorliegend in drei separate Schaltkreise 11, 12, 13, nämlich einen Primärschaltkreis 11, einen Sekundärschaltkreis 12 und einen Messschaltkreis 13, unterteilt ist.

Der schaltungstechnisch zwischen dem Primärschaltkreis 11 und dem Sekundärschaltkreis 12 angeordnete Messschaltkreis 13 ist mittels einer ersten 4 kV-Schutzisolierung (A) gegen den Primärschaltkreis 11 und mittels einer zweiten 4 kV-Schutzisolierung (B) gegen den Sekundärschaltkreis 12 schutzisoliert.

Dabei werden zwischen den leitfähigen Elementen der betreffenden Schaltkreise (11, 12; 12, 13) jeweils Mindest-Luftabstände von 3 mm und platinenseitige Mindest-Kriechstromabstände (Kriechstrecken) von ebenfalls 3, bevorzugt jedoch von 4 mm, eingehalten.

Ferner ist dafür Sorge getragen, dass der Sekundärschaltkreis 12 gegenüber dem Primärschaltkreis 13 mittels einer 8 kV-Schutzisolierung isoliert ist, zu welchem Zweck zwischen den leitfähigen Elementen der betreffenden Schaltkreise 11, 12 Mindest-Luftabstände von 6 mm und Mindest-Kriechstromabstände von 6,3 mm eingehalten werden.

Die den Primärschaltkreis 11 mit dem Messschaltkreis 13 koppelnden Widerstände R1, R2, R3, R4 und die Transformatoren (bzw. Netzteil-Übertrager) TR1, TR2, TR3 weisen zum Zwecke der vorgenannten Schutzisolierung ebenfalls eine Isolationsfestigkeit von wenigstens 4 kV auf. Gleiches gilt für den den Messschaltkreis 13 mit dem Sekundärschaltkreis 12 koppelnden integrierten Schaltkreis IC5.

Im Primärschaltkreis 11 sind zum Zwecke der Strommessung zwischen den verschiedenen Eingängen L1-In, L2-In, L3-In und Ausgängen L1-Out, L2-Out, L3-Out jeweils ein Shunt-Widerstand S1, S2, S3 angeordnet. Die an dem jeweiligen Shunt-Widerstand S1, S2, S3 abfallende Spannung wird über je einen integrierten Schaltkreis IC1, IC2, IC3 und je einen Transformator TR1, TR2, TR3 mit entsprechenden Eingängen M1, M2, M3 des im Messschaltkreis 13 angeordneten Smart-Metering-Mikrochips IC4 verbunden. Die integrierten Schaltkreise IC1, IC2, IC3 dienen zur Verstärkung der äußerst geringen Spannungen, die an dem jeweiligen Shunt-Widerstand S1, S2, S3 abfallen und gleichzeitig der Analog-Digital-Wandlung des jeweiligen Spannungssignals. Ferner sind auch die drei im Primärschaltkreis 11 angeordneten Phasen L1, L2, L3 des Dreiphasenwechselstroms über entsprechende Spannungsteiler mit Widerständen R1, R8; R2, R7; R3, R6 mit den entsprechenden Eingängen M1, M2, M3 des Smart-Metering Mikrochips IC4 verbunden.

Gleichermaßen wird auch das Nullleiterpotential N - über einen Spannungsteiler R4, R6 mit dem diesbezüglichen Eingang M4 des Smart-Metering-Chips kontaktiert, wobei innerhalb des Primärschaltkreises 11 mittels einer Funktionsisolierung (D) für eine hinreichende Schutzisolierung (Mindest-Luftabstand 3 mm; Mindest-Kriechstromabstand 3 mm) zwischen den auf Nullleiterpotential N liegenden Leitern und den drei Phasen L1, L2, L3 führenden Leitern Sorge getragen ist.

Die Kommunikation zwischen dem Smart-Metering-Chip IC4, dem weiteren integrierten Schaltkreis IC5 und den Datenkommunikationsschnittstellen 5, 6 bzw. weiteren in den Smart-Meter 1 integrierten Elektronikbausteinen (z.B. Speichermedien, Webserver, ...) erfolgt auf Basis eines geeigneten Kommunikationsprotokolls, nämlich z.B. auf Basis des vorliegend gewählten Serial-Peripheral-Interface (SPI)-Protokolls.

Im Rahmen des bevorzugten Ausführungsbeispiels der vorliegenden Erfindung können insbesondere die nachstehend genannten Bauteile Verwendung finden:

| Bauteil | Beschreibung | Hersteller / Bauteil | Isolationsfestigkeit |
|---|---|---|---|
| TR1, TR2, TR3 | Netzteil Übertrager | Würth / 750110056 | 5 kV DC, 1s |
| IC1, IC2, IC3 | 71M6x03 Isolated Sensor IC's | Maxim | - |
| IC4 | 71M6545/71M6545H Metrology Processor | Maxim | - |
| IC5 | Quad-Channel, 5kV Isolators with Integrated DC-to-DC-Converter | Analog Devices / ADuM6401ARWZ | 5kV DC, 60s |

Die Widerstände R1 - R4, die z.B. einen Widerstandswert von 10 MΩ aufweisen können, sind ebenfalls mit einer hinreichenden Spannungsfestigkeit zu wählen.

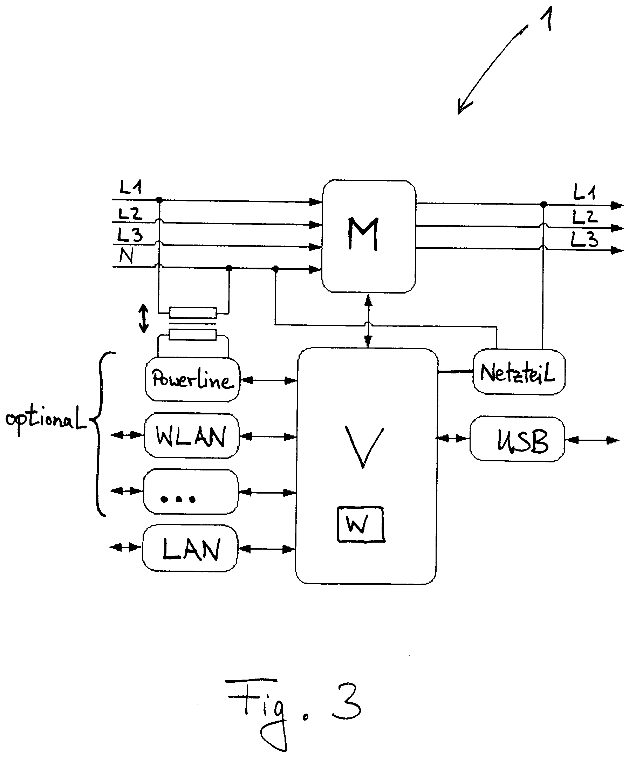

Fig. 3 zeigt schließlich noch ein Blockschaltbild zur Veranschaulichung der Systemarchitektur des erfindungsgemäßen Smart-Meters 1.

Die drei Phasen des Wechselstroms werden - mittels geeigneter Verschaltung (siehe oben) - zur Erfassung des tatsächlichen Stromverbrauchs in einer geeigneten Messschaltung M ausgewertet, wobei die Messschaltung M mit einer einen Webserver W beinhaltenden Datenverarbeitungseinheit V gekoppelt ist, die ihrerseits von einem an dem Primärschaltkreis angeschlossenen Netzteil mit Strom versorgt wird.

Mittels einer (optionalen) USB-Schnittstelle sowie einer LAN-Schnittstelle kann Zugriff auf die Datenverarbeitungseinheit V des Smart-Meters genommen werden, wobei optional noch (wenigstens oder genau) eine weitere Datenverarbeitungsschnittstelle (z.B. Powerline, WLAN, miniPCIe-Slot, KNX-RF, RS 485, CMS, LV, oder auf sonstigen Standards basierende Schnittstellen) vorgesehen sein kann. Der erfindungsgemäße Smart-Meter 1 dient dabei nicht nur zur Ausgabe des zurückliegenden und aktuellen Stromverbrauchs, sondern ist auch zur Steuerung externer Geräte eingerichtet.

## Patentansprüche

1. Smart-Meter (1) mit einer Elektronik (10) zur Erfassung des Stromverbrauchs und zur Ausgabe von den Stromverbrauch repräsentierenden Daten über eine Datenkommunikationsschnittstelle (5, 6) umfassend ein die Elektronik (10) aufnehmendes Gehäuse (2), welches zum Einbau in eine Hutschiene eines Verteilerkastens für ein Niederspannungsnetz geeignet ist,
wobei die Elektronik (10) des Smart-Meters (1) einen Primärschaltkreis (11) mit Anschlüssen (L1-In, L2-In, L3-In, L1-Out, L2-Out, L3-Out) für die drei Phasen eines Dreiphasenwechselstroms, einen Sekundärschaltkreis (12) mit mindestens einer auf einer Bedienseite (4) des Gehäuses (2) angeordneten Datenkommunikationsschnittstelle (5, 6) und einen zwischen dem Primärschaltkreis (11) und dem Sekundärschaltkreis (12) angeordneten Messschaltkreis (13) mit einem Smart-Metering-Mikrochip (IC4) aufweist,
wobei der Messschaltkreis (13) sowohl gegenüber dem Primärschaltkreis (11) als auch gegenüber dem Sekundärschaltkreis (12) eine Schutzisolierung (A, B) mit einer Isolationsfestigkeit von jeweils mindestens 3 kV aufweist, wobei die Summe der Isolationsfestigkeiten der beiden
Schutzisolierungen (A, B) wenigstens 8 kV beträgt und
wobei der Sekundärschaltkreis (12) gegenüber dem Primärschaltkreis (11) eine 8 kV-Schutzisolierung (C) aufweist.

2. Smart-Meter nach Anspruch 1,
**dadurch gekennzeichnet,**
**dass** zwischen dem Primärschaltkreis (11) und dem Messschaltkreis (13) sowie zwischen dem
Messschaltkreis (13) und dem Sekundärschaltkreis (12) jeweils eine 4 kV-Schutzisolierung (A, B) vorgesehen ist.

3. Smart-Meter nach Anspruch 2,
**dadurch gekennzeichnet,**
**dass** die 4 kV-Schutzisolierung (A, B) zwischen Messschaltkreis (13) und Primärschaltkreis (11) einerseits und zwischen Messschaltkreis (13) und Sekundärschaltkreis (12) andererseits dadurch realisiert ist, dass zwischen allen leitfähigen Elementen des Messschaltkreises (13) und des Primärschaltkreises (11) sowie zwischen allen leitfähigen Elementen des Messschaltkreises (13) und des Sekundärschaltkreises (12) stets ein Mindest-Luftabstand von 3 mm und ein platinenseitiger Mindest-Kriechstromabstand von 3 mm, bevorzugt von 4 mm, vorgesehen sind, wobei elektrische Bauteile (TR1, TR2, TR3, R1, R2, R3, R4; IC5), die den Primärschaltkreis (11) mit dem Messschaltkreis (13) sowie den Messschaltkreis (13) mit dem Sekundärschaltkreis (12) koppeln, ihrerseits jeweils eine 4 kV-Schutzisolierung aufweisen und
**dass** die 8 kV-Schutzisolierung zwischen Primär-(11) und Sekundärschaltkreis (12) dadurch realisiert ist, dass zwischen allen leitfähigen Elementen des Primär- (11) und
Sekundärschaltkreises (12) ein Mindest-Luftabstand von 6 mm und ein platinenseitiger Mindest-Kriechstromabstand von 6,3 mm vorgesehen sind.

4. Smart-Meter nach einem der vorangehenden Ansprüche,
**dadurch gekennzeichnet,**
**dass** das Gehäuse (2) eine Breite von maximal 4 Teilungseinheiten zu je 17,5 mm aufweist.

5. Smart-Meter nach einem der vorangehenden Ansprüche,
**dadurch gekennzeichnet,**
**dass** die mindestens eine Datenkommunikationsschnittstelle (5, 6) eine LAN-oder WLAN-Schnittstelle ist.

6. Smart-Meter nach einem der vorangehenden Ansprüche,
**dadurch gekennzeichnet,**
**dass** wenigstens zwei Datenkommunikationsschnittstellen (5, 6) vorgesehen sind, von denen die erste Datenkommunikationsschnittstelle (5) eine LAN-Schnittstelle ist, wobei die wenigstens eine weitere Datenkommunikationsschnittstelle (6) eine WLAN-Schnittstelle, eine Powerline-Schnittstelle, eine USB-Schnittstelle und/oder eine Schnittstelle zu einem Bus- oder einem Feldbussystem ist.

7. Smart-Meter nach einem der vorangehenden Ansprüche,
**dadurch gekennzeichnet,**
**dass** der Smart-Meter (1) ferner zur Steuerung wenigstens eines externen Geräts über die wenigstens eine Datenkommunikationsschnittstelle (5, 6) eingerichtet ist.

8. Smart-Meter nach einem der vorangehenden Ansprüche,
**dadurch gekennzeichnet,**
**dass** in das Gehäuse (2) des Smart-Meters (1) ein Webserver (W) integriert ist, so dass der gemessene Stromverbrauch von externen Geräten über das Internet abgefragt werden kann.

## Claims

1. A smart meter (1) with electronics (10) for detecting current consumption and for the output of data representing the current consumption via a data communication Interface (5, 6), comprising a housing (2) accommodating the electronics (10), said housing being suitable for installation in a top-hat rail of a distributor box for a low voltage network,
wherein the electronics (10) of the smart meter (1) comprises a primary circuit (11) with connections (L1-In, L2-In, L3-in, L1-Out, L2-OUt, L3-Out) for the three phases of a three-phase alternating current, a secondary circuit (12) with at least one data communication interface (5, 6) arranged on an operator side (4) of the housing (2) and a measuring circuit (13) with a smart metering microchip (IC4) arranged between the primary circuit (11) and the secondary circuit (12),
wherein the measuring circuit (13) comprises a protective insulation (A, B) with an insulating resistance of at least 3 kV both with respect to the primary circuit (11) and respectively with respect to the secondary circuit (12), wherein the sum of the insulation resistances of the two protective insulations (A, B) amounts to at least 8 kV
and
wherein the secondary circuit (12) comprises an 8 kV protective insulation (C) with respect to the primary circuit (11).

2. The smart meter according to claim 1,
**characterised in that**
a 4 kV protective insulation (A, B) is provided respectively between the primary circuit (11) and the measuring circuit (13) and between the measuring circuit (13) and the secondary circuit (12).

3. The smart meter according to claim 2,
**characterised in that**
the 4 kV protective insulation (A, B) between the measuring circuit (13) and the primary circuit (11) on the one hand and between the measuring circuit (13) and the secondary circuit (12) on the other hand is achieved by the fact that a minimum air gap of 3 mm and a minimum leakage current gap on the circuit board side of 3 mm, preferably of 4 mm, are always provided between all conductive elements of the measuring circuit (13) and the primary circuit (11) and between all conductive elements of the measuring circuit (13) and the secondary circuit (12),
wherein electrical components (TR1, TR2, TR3, R1, R2, R3, R4; IC5), which couple the primary circuit (11) with the measuring circuit (13) and the measuring circuit (13) with the secondary circuit (12), for their part each comprise a 4 kV protective insulation and
that the 8 kV protective insulation between the primary circuit (11) and the secondary circuit (12) is achieved by the fact that a minimum air gap of 6 mm and a minimum leakage current gap of 6.3 mm on the circuit board side are provided between all conductive elements of the primary circuit (11) and secondary circuit (12).

4. The smart meter according to any one of the preceding claims,
**characterised in that**
the housing (2) has a width of at most 4 division units each of 17.5 mm.

5. The smart meter according to any one of the preceding claims,
**characterised in that**
the at least one data communication interface (5, 6) is a LAN- or WLAN-interface.

6. The smart meter according to any one of the preceding claims,
**characterised in that**
at least two data communication interfaces (5, 6) are provided, whereof the first data communication interface (5) is a LAN-interface, wherein the at least one further data communication interface (6) is a WLAN-interface, a powerline interface, a USB-interface and/or an interface to a bus system or a field bus system.

7. The smart meter according to any one of the preceding claims,
**characterised in that**
the smart meter (1) is further equipped for controlling at least one external device via the at least one data communication interface (5, 6).

8. The smart meter according to any one of the preceding claims,
**characterised in that**
a webserver (W) is integrated into the housing (2) of the smart meter (1), so that the measured current consumption can be retrieved from external devices via the Internet.

## Revendications

1. Compteur intelligent (1) avec un système électronique (10), destiné à recenser la consommation électrique et à éditer des données représentant la consommation électrique par l'intermédiaire d'une interface de communication de données (5, 6), comprenant un boîtier (2) recevant le système électronique (10), lequel est apte à être encastré dans un profilé chapeau d'un coffret de distribution pour un réseau basse tension,
le système électronique (10) du compteur intelligent (1) comportant un circuit primaire (11) avec des raccords (L1-In, L2-In, L3-In, L1-Out, L2-Out, L3-Out) pour les trois phases d'un courant alternatif triphasé, un circuit secondaire (12) avec au moins une interface de communication de données (5, 6) placée sur une face de commande (4) du boîtier (2) et un circuit de mesure (13) placé entre le circuit primaire (11) et le circuit secondaire (12), avec une micro-puce de comptage intelligent (IC4),
le circuit de mesure (13) comportant aussi bien par rapport au circuit primaire (1l) qu'également par rapport au circuit secondaire (12) une isolation protectrice (A, B) avec une résistance d'isolation de chaque fois au moins 3 kV, la somme des résistances d'isolation des deux isolations protectrices (A, B) s'élevant à au moins 8 kV et
le circuit secondaire (12) comportant par rapport au circuit primaire (11) une isolation protectrice (C) de 8 kV.

2. Compteur intelligent selon la revendication 1,
**caractérisé en ce**
**qu'**entre le circuit primaire (11) et le circuit de mesure (13), ainsi qu'entre le circuit de mesure (13) et le circuit secondaire (12), il est prévu chaque fois une isolation protectrice (A, B) de 4 kV.

3. Compteur intelligent selon la revendication 2,
**caractérisé en ce que**
l'isolation protectrice (A, B) de 4 kV entre le circuit de mesure (13) et le circuit primaire (11) d'une part et entre le circuit de mesure (13) et le circuit secondaire (12) d'autre part est réalisée **en ce qu'**entre tous les éléments conducteurs du circuit de mesure (13) et du circuit primaire (11), ainsi qu'entre tous les éléments conducteurs du circuit de mesure (13) et du circuit secondaire (12), il est toujours prévu un entrefer minimal de 3 mm et une ligne de fuite minimale de 3 mm, de préférence de 4 mm, du côté de la carte de circuits,
des composants électriques (TR1, TR2, TR3, R1, R2, R3, R4 ; IC5), qui connectent le circuit primaire (11) avec le circuit de mesure (13), ainsi que le circuit de mesure (13) avec le circuit secondaire (12) comportent pour leur part chacun une isolation protectrice de 4 kV,
**en ce que** l'isolation protectrice de 8 kV entre le circuit primaire (11) et le circuit secondaire (12) est réalisée **en ce qu'**entre tous les éléments conducteurs du circuit primaire (11) et du circuit secondaire, (12) il est prévu un entrefer minimal de 6 mm et une ligne de fuite minimale de 6,3 mm du côté de la carte de circuits.

4. Compteur intelligent selon l'une quelconque des revendications précédentes,
**caractérisé en ce que**,
le boîtier (2) présente une largeur d'un maximum de 4 unités modulaires de 17,5 mm chacune.

5. Compteur intelligent selon l'une quelconque des revendications précédentes,
**caractérisé en ce que**,
l'au moins une interface de communication de données (5, 6) est une interface LAN ou WLAN.

6. Compteur intelligent selon l'une quelconque des revendications précédentes,
**caractérisé en ce**
**qu'**il est prévu au moins deux interfaces de communication de données (5, 6) dont la première interface de communication de données (5) est une interface LAN, l'au moins une interface de communication de données (6) supplémentaire étant une interface WLAN, une interface Powerline, une interface USB et/ou une interface vers un système de bus ou un système de bus de terrain.

7. Compteur intelligent selon l'une quelconque des revendications précédentes,
**caractérisé en ce que**
par ailleurs le compteur intelligent (1) est ménagé pour commander au moins un appareil externe via l'interface de communication de données (5, 6).

8. Compteur intelligent selon l'une quelconque des revendications précédentes,
**caractérisé en ce que**
dans le boîtier (2) du compteur intelligent (1) est intégré un serveur Internet (W), de sorte que la consommation électrique mesurée peut être interrogée par des appareils externes via Internet.
